# EUROPEAN PATENT APPLICATION

(11) **EP 1 568 657 A2**
(43) Date of publication of application: **31.08.2005**
(21) Application number: 05251031.0
(22) Date of filing: 23.02.2005
(51) Int. Cl.: B81C 1/00, G11B 5/855

(54) **Method of manufacturing nanostructure arrays**

(30) Priority: 25.02.2004 GB 0404120
(71) Applicant: The Queen's University of Belfast, Belfast BT7 1NN (GB)
(72) Inventor: Douglas, Connor David, Co. Down, BT30 6US, Northern Ireland (GB); Pollard, Robert James, Co. Down, Northern Ireland (GB)
(74) Representative: Jones, Keith William

(57) **Abstract**

A method of disposing a plurality of isolated particles of a first material onto a substrate comprising the steps of:
(a) depositing a first species onto the substrate;
(b) anodizing the first species to produce a second species;
(c) altering the surface of the second species so that at least one first region of the second species is of greater thickness than at least one second region of the second species;
(d) depositing the first material onto the second species; and
(e) levelling the surface of the first material and the second species.

## Description

The present invention relates to a method of manufacturing nanostructure arrays.

### Background of the Invention

The ever-growing demand for smaller and more powerful microelectronic circuits has manifested itself in a reduction of the area and volume needed by on-board transistors. In a similar fashion, the demand for increased capacity storage devices has led to the storage of information in ever-decreasing spaces on storage media (i.e. thereby increasing its storage density).

Traditional magnetic recording devices employ media comprised of inter-connected magnetic particles. However, these media generate noise whose magnitude depends on the size and orientation of the inter-connected magnetic particles. This noise has become increasingly problematic as data bits are stored in ever-smaller areas of the recording media. Consequently, attention has moved away from storage materials with inter-connected magnetic particles to those with isolated magnetic particles.

A nanostructure is a material structure assembled from a layer or cluster of atoms. Nanostructures are typically sized in nanometers and include quantum dots, quantum wires, nanotubes, nanocrystals, and ultra-thin multilayer films. Many materials exhibit novel optical, electrical and/or optical behaviour at sizes below a few hundred nanometers as quantum mechanical principles begin to dominate material properties. The increased surface area of nanostructures compared with conventional materials is of particular interest to storage device designers because it provides the possibility for increased storage density.

High surface areas can be attained either by fabricating small particles or clusters where the surface-to-volume ratio of each particle is high, or by creating materials where the void surface area (pores) is high compared to the amount of bulk support material. In general however, there are two approaches to the synthesis and fabrication of high surface area nanostructures, namely "top-down" and "bottom-up" techniques.

### (1) "Top-Down" Techniques

In "top-down" fabrication techniques, nanostructures are created by carving, moulding or machining bulk and thin film materials with tools and lasers. Top-down techniques include mechanical milling, photolithography and e-beam lithography.

### (2) Bottom-Up Approach

In "bottom-up" fabrication techniques, nanostructures are spontaneously built up from individual atoms or molecules or formed from chemical reordering of a material. These techniques are also known as self-assembly or self-ordering techniques and include gas condensation, chemical precipitation, aerosol reactions and biological templating.

Anodization, is a well-known self-assembly technique and the method of forming alumina by anodizing aluminium is particularly well-known. In this example an aluminium foil is anodized using a suitable acid to produce a porous alumina membrane. The membrane has a geometrical structure determined by the anodizing conditions so that the pores may be regularly or irregularly formed in the membrane with diameters ranging from a few nanometers to several hundred nanometers.

In order to ensure a regular pore structure in the membrane, a double anodization technique may be used in which the first anodization is stopped and subsequently restarted after removal of the initially anodized material. Alternatively, an imprint technique may be used to pre-form the surface prior to anodization (Masuda et al, Science, 268(5216), 1466-1468 (1995) and Asoh et al, J.Vac.Sci.Technol. B, 19(2), 569-572,(2001)).

The pore structure formed by the anodizing technique may be used as a template through which materials may be deposited (Liu et al, Appl.Phys.Lett. Vol.81(23), 4434-4436,(2002)). Prior to anodization, aluminium may be deposited by physical vapour deposition onto a planar substrate which had previously been coated with a material to act as a backing plate. This pre-processing step enables growth up into the pores after anodizing by electrodepositing onto the backing plate (Choi et al, J.Mater.Chem. Vol. 13(5), 1100-1103,(2003)).

According to the invention there is provided a method of disposing a plurality of isolated particles of a first material onto a substrate comprising the steps of:
(a) depositing a first species onto the substrate;
(b) anodizing the first species to produce a second species;
(c) altering the surface of the second species so that at least one first region of the second species is of greater thickness than at least one second region of the second species;
(d) depositing the first material onto the second species; and
(e) levelling the surface of the first material and the second species.

Preferably, the substrate is glass.

Optionally, the substrate is silicon.

Optionally, the substrate is a conducting species.

Preferably, the first species is aluminium.

Desirably, the first species is deposited onto the substrate by physical vapour deposition.

Optionally, the first species is deposited onto the substrate by chemical vapour deposition.

Preferably, the first species is deposited onto the substrate in a thickness not less than 20nm.

Optionally, a third species is deposited onto the substrate before the first species.

Optionally, the deposited first species is treated before the anodization process to ensure a desired anodization pattern.

Preferably, the surface of the second species is altered by ion milling.

Optionally, the surface of the second species is altered by reactive ion etching.

Optionally, the surface of the second species is altered by atom milling.

Preferably, the surface of the second species is altered by a milling means disposed at an angle of incidence of between 0° and 60° measured from the normal to the surface of the substrate.

Preferably, each of the at least one second regions of the second species surrounds one of an at least one pores in the second species resulting from the anodization process.

Desirably, the at least one first regions of the second species are disposed between each of the at least one pores in the second species resulting from the anodization process.

Preferably, the first material is deposited onto the surface of the second species by physical vapour deposition.

Preferably, the first material comprises at least one layer of at least one species.

Desirably, the surface of the first material and the second species are levelled by ion milling.

Optionally, the surface of the first material and the second species are levelled by atom milling.

Preferably, the surface of the first material and the second species are levelled by a milling means disposed at an angle of incidence between 30° to 90° measured from the substrate surface normal.

Whilst nanostructures are typically constructed using top-down or bottom-up techniques as described earlier, the present manufacturing method takes the novel and inventive approach of combining techniques to produce a nanoarray by physical vapour deposition, anodization and ion milling. Consequently, the present manufacturing method offers a way of creating patterned media that removes the need for lithographic techniques and is thus of particular benefit for high-density recording systems design.

An embodiment of the invention will now be described by way of example only with reference to the accompanying drawings in which:
Figure 1 is a cross-sectional view of an aluminium layer deposited onto a substrate in accordance with a first step of a method of disposing a plurality of isolated particles of a first material onto the substrate;
Figure 2 is a cross-sectional view of the substrate coated with a porous alumina membrane as a result of a second step of the method of disposing a plurality of isolated particles of a first material onto the substrate;
Figure 3(a) is a cross-sectional view of an ion/atom milled porous alumina membrane coated onto the substrate in accordance with step 3 of the method of disposing a plurality of isolated particles of a first material onto the substrate;
Figure 3(b) is a top-plan view of the ion/atom milled anodized alumina membrane shown in Figure 3(a);
Figure 4 is a cross-sectional view of a first material physically vapour deposited onto the milled anodized alumina membrane in accordance with step 4 of the method of disposing a plurality of isolated particles of the first material onto the substrate;
Figure 5(a) is a cross-sectional view of the substrate with the anodized alumina membrane and the first material deposited thereon following oblique milling in accordance with step 5 of the method of disposing a plurality of isolated particles of a first material onto the substrate; and
Figure 5(b) is a top plan view of substrate with anodized alumina membrane and the first material particles deposited thereon following oblique milling in accordance with step 5 of the method of disposing a plurality of isolated particles of the first material onto the substrate.

For the sake of brevity and clarity, the method of disposing a plurality of isolated particles of a first material onto a substrate will be known henceforth as the manufacturing method.

The manufacturing method is divided into five steps as follows:
- step 1:: depositing aluminium onto a suitable substrate;
- step 2:: anodizing the aluminium deposit;
- step 3:: ion/atom milling the surface of the anodized alumina to produce a topographical surface;
- step 4:: physical vapour deposition of a material onto the milled anodized alumina surface; and
- step 5:: oblique milling of surface resulting from step 4 to form and planarize the surface of an array.

### Step 1: Depositing Aluminium onto a Suitable Substrate

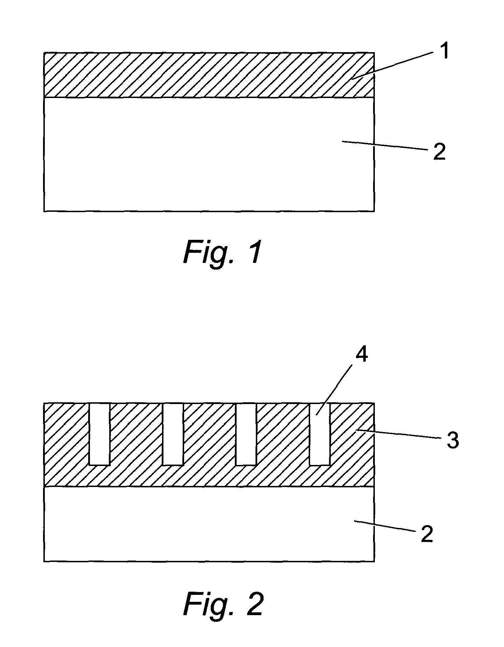

Referring to Figure 1, in a first step of the manufacturing method a layer of aluminium 1 is deposited onto a suitable substrate 2 by physical vapour or chemical vapour deposition.

The substrate may be an insulating material such as glass, a semi-conducting material such as silicon or a metal. The deposited aluminium layer should be no less than 20nm in thickness.

In addition, an underlayer, conducting layer or combination of layers may be deposited onto the substrate 2 prior to the deposition of the aluminium layer 1.

### Step 2: Anodizing the Deposited Aluminium Layer

Referring to Figure 2, in the second step of the manufacturing method the aluminium layer 1 is anodized in a suitable acid.

The anodization may be carried out as a single or two-stage process, although it is not necessary to completely anodize the aluminium layer 1. Prior to the anodization step, the aluminium layer 1 may also be treated by imprinting (or other method) to produce a desired pore 4 pattern.

As a result of the anodization, the aluminium layer 1 is converted into a non-uniformly dense alumina membrane 3 with regularly or irregularly disposed pores 4.

### Step 3: Ion/Atom Milling the Surface of the Anodized Alumina Layer to Produce a Topographical Surface

In the third step of the manufacturing method the surface of the porous alumina membrane 3 is subjected to ion/atom milling. The milling technique employs an ion/atom source (e.g. Kaufmann type) with an appropriate gas (e.g. inert such as argon, krypton or other O₂, N₂) to remove material from the surface of the porous alumina membrane 3. To facilitate the required milling activity, the ion beam should be directed at the surface of the porous alumina membrane 3 with an angle of incidence of between 0° to 60° measured from the substrate surface normal.

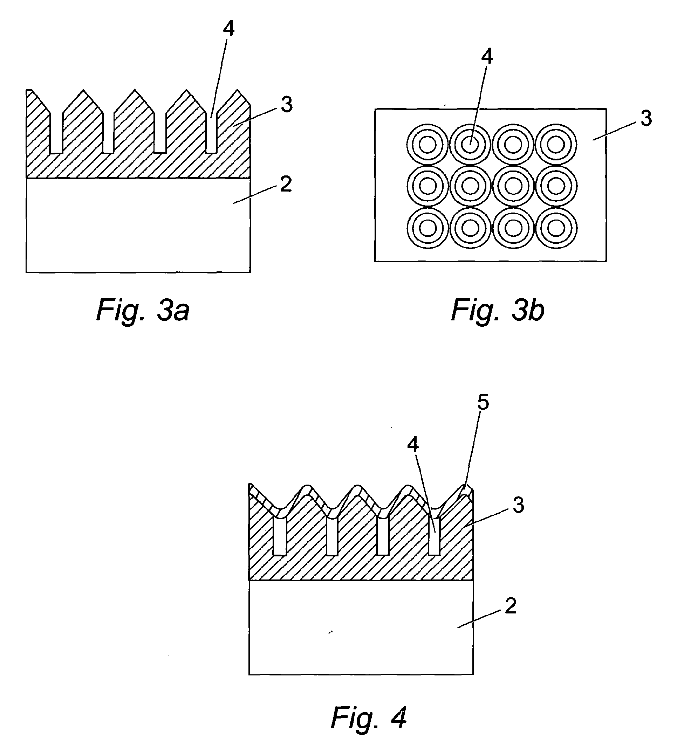

The milling causes preferential etching closer to the pores 4 so that (referring to Figure 3(b)) the region of the porous alumina membrane 3 closest to the pores 4 is milled down to a reduced height whilst the region in-between the pores 4 is less affected (i.e. remains high). Referring to Figure 3(a), this results in a characteristic saw-wave pattern on the surface of the porous alumina membrane 3.

### Step 4: Physical Vapour Deposition of a material onto the Milled Anodized Alumina Surface

Referring to Figure 4, in the fourth step of the manufacturing method a material 5 is physically vapour deposited (e.g. sputtering) onto the saw-wave surface of the milled porous alumina membrane 3. The material 5 may be a single layered (e.g. Au, CoPt alloy, BaTi0₃ compound) or a complex layered material (e.g. Co/Pt multilayer).

As a result of the deposition process, the material 5 is deposited conformally over the elevated portions of the milled porous alumina membrane 3 (i.e. in the region between the pores 4) and remains connected over the pores 4.

Previous studies have attempted to fill the pores 4 in the porous alumina membrane 3 by electrochemistry, or alternatively, have used the pores as templates for a deposition mask. In contrast, in the present manufacturing method, the material 5 does not break up and fall into the pores 4 as might be expected, but instead effectively forms a continuous blanket (connected by contact at the edges of pores 4) over the milled surface of the porous alumina membrane 3. As a result, the deposited material exhibits peaks and troughs mirroring the elevated regions (in-between the pores 4) and depressed regions (close to the pores 4) of the alumina membrane 3.

### Step 5: Oblique Milling of Surface Resulting from Step 4 to Form and Planarize the Surface of an Array

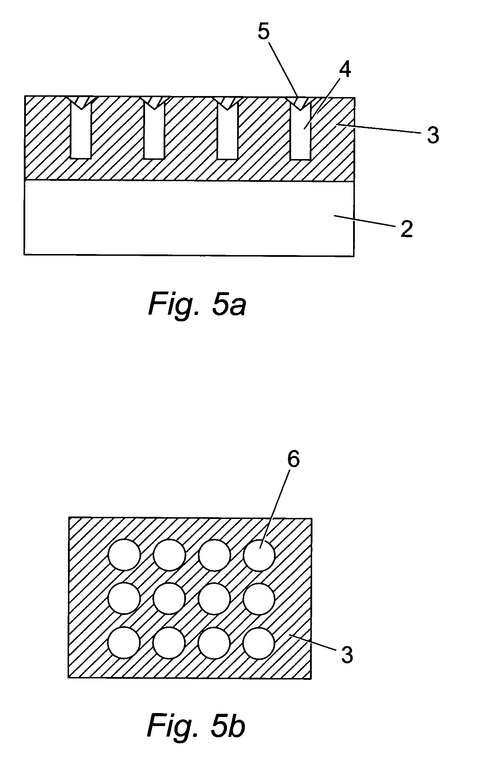

Referring to Figures 5(a) and 5(b), in the fifth step of the manufacturing method, the surface of the vapour deposited material 5 is subjected to ion/atom milling at an oblique angle of incidence (i.e. wherein the milling angle is between 30° to 90° from the surface normal). This process removes the elevated regions of the material 5 and the porous alumina membrane 3 so that the resulting planar alumina surface contains isolated nano-particles 6 of material 5 located above each pore 4 formed during the anodization step.

In effect this milling process takes advantage of the peaks in the material 5 and the porous alumina membrane 3 to shadow and protect the troughs in the material 5 and the porous alumina membrane 3 surrounding the pores 4. From the above, it is clear that the spacing and size of the nano particles 6 can be altered by modifications to the anodizing conditions and subsequent ion milling.

Improvements and modifications can be made to the above without departing from the scope of the invention.

## Claims

1. A method of disposing a plurality of isolated particles of a first material onto a substrate comprising the steps of:
(a) depositing a first species onto the substrate;
(b) anodizing the first species to produce a second species;
(c) altering the surface of the second species so that at least one first region of the second species is of greater thickness than at least one second region of the second species;
(d) depositing the first material onto the second species; and
(e) levelling the surface of the first material and the second species.

2. A method as claimed in claim 1 wherein the substrate is a substance selected from the group comprising glass, silicon and a conducting substance.

3. A method as claimed in claim 1 or 2 wherein the first species is aluminium.

4. A method as claimed in any of the preceding claims wherein the first species is deposited onto the substrate by a procedure selected from the group comprising physical vapour deposition and chemical vapour deposition.

5. A method as claimed in any of the preceding claims wherein the first species is deposited onto the substrate in a thickness not less than 20nm.

6. A method as claimed in any of the preceding claims wherein a third species is deposited onto the substrate before the first species.

7. A method as claimed in any of the preceding claims wherein the deposited first species is treated before the anodization process to ensure a desired anodization pattern.

8. A method as claimed in any of the preceding claims wherein the surface of the second species is altered by a procedure selected from the group comprising ion milling, reactive ion etching and atom milling.

9. A method as claimed in any claim 8 wherein the surface of the second species is altered by a milling means disposed at an angle of incidence of between 0° and 60° measured from the normal to the surface of the substrate.

10. A method as claimed in any of the preceding claims wherein each of the at least one second regions of the second species surrounds one of an at least one pores in the second species resulting from the anodization process.

11. A method as claimed in any of the preceding claims wherein the at least one first regions of the second species are disposed between each of the at least one pores in the second species resulting from the anodization process.

12. A method as claimed in any of the preceding claims wherein the first material is deposited onto the surface of the second species by physical vapour deposition.

13. A method as claimed in any of the preceding claims wherein the first material comprises at least one layer of at least one species.

14. A method as claimed in any of the preceding claims wherein the surface of the first material and the second species are levelled by a procedure selected from the group comprising ion milling and atom milling.

15. A method as claimed in claim 14 wherein the surface of the first material and the second species are levelled by a milling means disposed at an angle of incidence between 30° to 90° measured from the substrate surface normal.
